# EUROPEAN PATENT APPLICATION

(11) **EP 1 811 552 A1**
(43) Date of publication of application: **25.07.2007**
(21) Application number: 04799570.9
(22) Date of filing: 10.11.2004
(51) Int. Cl.: H01L 21/304

(54) **SINGLE-WAFER PROCESSOR**

(71) Applicant: Mimasu Semiconductor Industry Co., Ltd., Takasaki-shi, Gunma 370-3533 (JP)
(72) Inventor: TSUCHIYA, Masato, MIMASU SEMICONDUCTOR I. Co Ltd, Gunma-machi, Gunma-gun, Gunma 3703521 (JP); OGASAWARA, Syunichi, MIMASU S. I. Co. Ltd, Gunma-machi, Gunma-gun, Gunma 3703521 (JP)
(74) Representative: Strasser, Wolfgang
(86) International application number: PCT/JP2004/016672
(87) International publication number: WO 2006/051585

(57) **Abstract**

The present invention provides a single wafer processor structured such that similar immersion treatment to the conventional immersion treatment can be performed in the spin treatment, that a consumption of the chemical solutions can be reduced in the chemical solution treatment per wafer, that energy saving can be realized by using reaction heat of the chemical solutions to eliminate a necessity of a heating heater, that a problem of deterioration of the chemical solutions can be eliminated since the blending of the chemical solutions is implemented on the rotary disk part and the chemical solutions are used immediately thereafter, and that the maximum effective point of the chemical solutions can be utilized. The processor of the present invention includes: a rotary disk (12) having medium flow passages on an upper surface thereof; a plurality of wafer receiving parts (18) provided on the upper surface of the rotary disk; an annular dam member (48) located outward of an outer circumferential edge of a wafer (w) mounted on the wafer receiving parts and provided so that an upper edge of the annular dam member can be located at an upper level than an upper surface of the wafer thus mounted; and nozzle means (60a-d), provided above the wafer mounted on the wafer receiving parts, for supplying a chemical solution and rinse water.

## Description

### Technical Field

The present invention relates to a single wafer processor capable of performing spin treatment and immersion treatment for a wafer, in particular, for a semiconductor wafer.

### Background Art

With regard to a wafer processor that performs spin treatment such as spin etching, a degree of recognition thereof by the name of a spin processor and the like has been enhanced in recent years particularly as a diameter of a semiconductor wafer has been enlarged. The reason of the above is that single wafer spin treatment has attracted attention as a method of easily implementing disposal (1pass) treatment for chemical solutions, inwhich an amount of the chemical solutions to be used per wafer is suppressed to the minimum, and a treatment level of cleaning and the like is set to the highest level, in terms of an increase of the chemical solutions owing to such diameter enlargement of the wafer, an enhancement of a particle level as a circuit pattern becomes finer, a prevention of a cross contamination for the purpose of reducing a contamination, and the like. The applicant of this application has made various proposals for this type of single spin processor (Patent Documents 1 and 2).

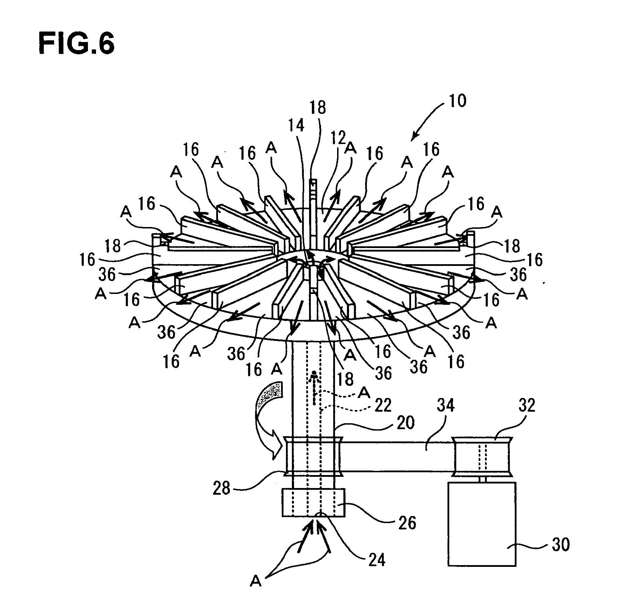

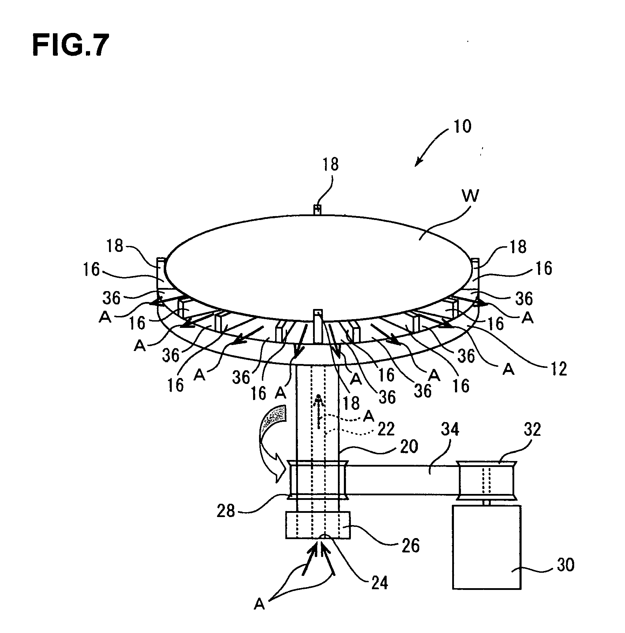

Now, a description will be made of structure examples of a conventional single spin processor with reference to FIG. 6 and FIG. 7. FIG. 6 is a perspective explanatory view showing an example of the conventional single spin processor, and FIG. 7 is a perspective explanatory view showing a state where a wafer is held on the single spin processor of FIG. 6.

In FIGS. 6 and 7, reference symbol 10 denotes a wafer holding apparatus, which has a rotary disk 12. A thorough hole 14 is drilled in a center of the rotary disk 12. On an upper surface of the rotary disk 12, a plurality (sixteen in the illustrated example) of blade plates 16 are erected radially at a predetermined interval.

On outer ends of upper surfaces of the plurality of blade plates 16, wafer receiving parts 18 which receive an outer circumference of a wafer W are provided. No particular limitations are imposed on a shape of the wafer receiving parts 18 as long as the wafer receiving parts 18 can receive the outer circumference of the wafer W; however, the wafer receiving parts 18 are formed into receiving step parts in the illustrated example. It is not always necessary that the wafer receiving parts 18 be provided on the blade plates 16, and it is also possible to provide the wafer receiving parts 18 directly on the upper surface of the rotary disk 12 as long as no trouble occurs. Further, the number of wafer receiving parts 18 to be installed just needs to be the number, for example, three or more, by which the wafer W can be held even in a state where the wafer W is rotating. However, in the illustrated example, the case is shown, where four wafer receiving parts 18 are provided at symmetric positions.

Reference symbol 20 denotes a rotary shaft provided on a center of a lower surface of the rotary disk 12 perpendicularly thereto, inside of which a hollow portion 22 communicating with the through hole 14 is drilled in an axial direction. The hollow portion 22 is open at a lower end of the rotary shaft 20, thereby forming a lower opening portion 24.

Onto a lower end portion of the rotary shaft 20, pressure reducing means 26, that is, a pressure reducing valve in the illustrated example, is attached. The pressure reducing means 26 can control an amount of air flowing in the hollow portion 22 of the rotary shaft 20 by adjusting an opening degree of the hollow portion 22. In the illustrated example, a case is shown, where the pressure reducing means 26 is provided on the lower end portion of the rotary shaft 20; however, the pressure reducing means 26 just needs to be able to adjust the opening degree of the hollow portion 22, it is not always necessary to provide the pressure reducing means 26 on the lower end portion, and the pressure reducingmeans 26 can be installed at an appropriate position such as an intermediate portion and upper portion of the rotary shaft 20.

Reference symbol 28 denotes a pulley provided on a lower portion of the rotary shaft 20, and the pulley 28 is connected to a motor pulley 32 of a motor 30 through a pulley belt 34. A structure is adopted, in which, when the motor 30 is driven, the motor pulley 32 rotates, rotation thereof is transmitted to the pulley 28 through the pulley belt 34, and the rotary shaft 20 rotates.

In the above-mentioned conventional apparatus 10, besides gas such as, the air, and liquid such as, pure water, the chemical solution, and one obtained by mixing both thereof are used as a medium. However, by taking as an example the case of using the air as the medium, a function of the example will be described.

First, as shown in FIG. 7, the wafer W is disposed above the upper surface of the rotary disk 12 through the wafer receiving parts 18, that is, keeping an interval therebetween. Specifically, the wafer W is disposed above the upper surfaces of the blade plates 16, keeping an interval. Moreover, the opening degree of the hollow portion 22 of the rotary shaft 20 is adjusted by the pressure reducing means 26 such that the inside of the hollow portion 22 can be set at an optimum reduced-pressure state corresponding to a thickness of the wafer W. A degree of pressure reduction in the hollow portion 22 becomes small when the opening of the hollow portion 22 is widened, and the degree of pressure reduction becomes large when the opening is narrowed. Note that, naturally, such a reduced-pressure state can be formed on the surface of the rotary disk 12 even in a structure where the through hole 14 is not drilled, and the wafer W can be held by suction force from the reduced-pressure state.

Such adjustment of the reduced-pressure state can be performed by adjusting a rotation speed of the rotary disk 12 as well as the above-mentioned opening degree of the hollow portion 22. The degree of pressure reduction becomes large when the rotation of the rotary disk 12 is accelerated, and the degree of pressure reduction becomes smaller when the rotation is decelerated.

When the motor 30 is driven in this state, rotation of the motor 30 is transmitted to the rotary shaft 20 through the motor pulley 32, the pulley belt 34 and the pulley 28, and the rotary disk 12 coupled to the rotary shaft 20 rotates. When the rotary disk 12 rotates, the medium (air in the case of the illustrated example) on the upper surface of the rotary disk 12 is discharged to the outside by centrifugal force caused by the rotation, and specifically, the medium A on the rotary disk 12 is discharged to the outside through a plurality of medium flow passages 36 formed in spaces among the upper surface of the rotary disk 12, the blade plates 16, each pair of which is opposite to each other, and a lower surface of the wafer W.

Insides of the medium flow passages 36 turn into the reduced-pressure state by the discharge of the medium A to the outside. By suction force from the pressure-reduced state, the medium A inhaled from the lower opening portion 24 of the hollow portion 22 of the rotary shaft 20 is supplied to the upper surface of the rotary disk 12 through the hollow portion 22 and the through hole 14, subsequently, the medium A is continuously exhausted to the outside through the insides of the medium flow passages 36. Then, the insides of the medium flow passages 36 are consecutively maintained at the pressure-reduced state.

As long as the rotary disk 12 continues to rotate, the insides of the medium flow passages 36 are maintained in the pressure-reduced state. The outer circumference of the wafer W is fixed and held on the wafer receiving parts 18 by the suction force from the pressure-reduced state of the medium flow passages 36. At this time, a back surface of the wafer W is located above upper surfaces of the blade plates 16, and is not brought into contact with the upper surfaces of the blade plates 16.

In the example shown in FIGS. 6 and 7, the case is shown, where the blade plates 16 are erected radially on the upper surface of the rotary disk 12. However, the blade plates 16 can also be provided in a helical shape as shown in FIG. 8 or in a spiral shape as shown in FIG. 9. In a case of providing the blade plates 16 in the radial shape or the helical shape, it is necessary to provide the plurality of medium flow passages 36 by using the plurality of blade plates 16. However, in a case of providing the blade plates 16 in the spiral shape, although the plurality of blade plates 16 can be naturally used, similar function and effect can be achieved even by forming one medium flow passage 36 by using one blade plate 16 as shown in FIG. 9.

Note that, in the illustrated example, there is shown an example in which the blade plates 16 are erected on the upper surface of the rotary disk 12 as separate bodies therefrom, however, the blade plates 16 just need to be formed such that the medium flow passages 36 can be formed on the upper surface of the rotary disk 12 by the blade plates 16. For example, portions of the medium flow passages 36 are dug in a groove shape, and portions of the blade plates 16 are left in a swelled state, thus also making it possible to provide the blade plates 16 integrally with the upper surface of the rotary disk 12.

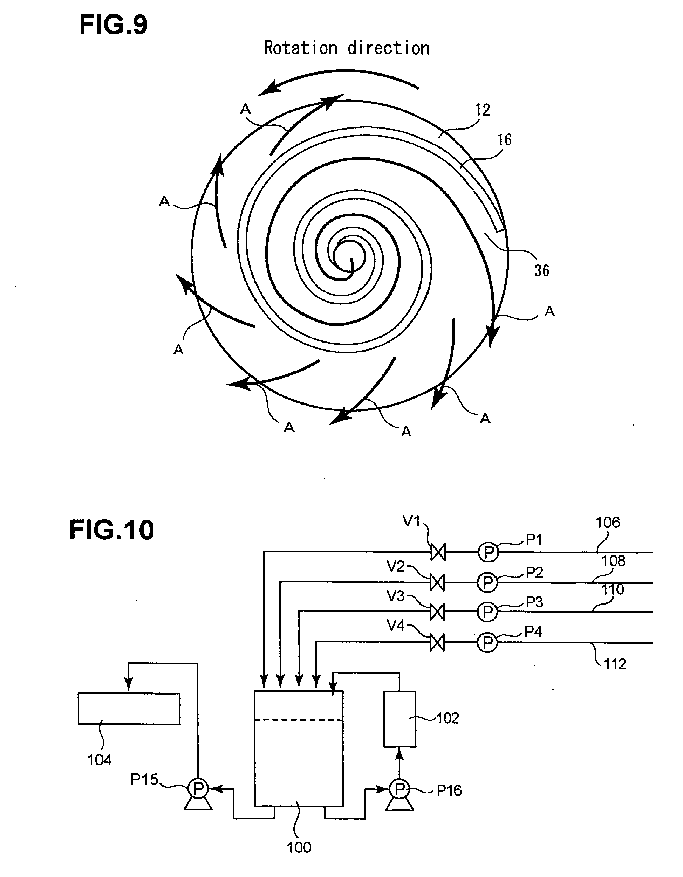

In the above-mentioned conventional single spin processor 10, as shown in FIG. 10, mixing of chemical solutions has been implemented in a mixed chemical solution tank 100, the treatment chemical solution has been prepared, a temperature thereof has been raised and adjusted by a heater 102, and the treatment chemical solution has been sent to a work processing point 104, where the treatment has been performed. In general, a capacity of the chemical solution tank 100 has been within a range of 20L to 50L. When a deteriorated amount of the chemical solutions has been supplemented and a fixed time or more has elapsed in a time management from the first preparation of the chemical solution, it has been necessary to drain and reprepare the chemical solutions. In FIG. 10, reference symbol 106 denotes a first chemical solution pipe, reference symbol 108 denotes a second chemical solution pipe, reference symbol 110 denotes a pure water pipe, reference symbol 112 denotes a hot pure water pipe, reference symbols P1, P2, P3, P4, P15 and P16 denote pump means, and reference symbols V1, V2, V3 and V4 denote valve means . In the above-mentioned conventional single spin processor 10, the chemical solutions are flown down to the rotating wafer from a nozzle located above the wafer, and the treatment such as cleaning is performed by a reaction effect of the chemical solutions when the chemical solutions pass on the wafer. A conventional method of immersing the wafer is more effective in some cases depending on the treatment contents for the wafer, and a single spin processor particularly capable of treating the front and back surfaces of the wafer simultaneously has been desired.
Patent Document1: JP 2001-148414 A
Patent Document2: JP 2001-267278 A

### Disclosure of the Invention

### Problems to be solved by the Invention

As a result of an assiduous study for the purpose of improving the above-mentioned conventional single spin processor, the inventors of the present invention have discovered that the conventional method of immersing the wafer is more effective in some cases depending on the treatment contents for the wafer, in particular, with regard to the wafer which needs to treat the front surface and the back surface simultaneously, the comprehensive and maximum effect can be obtained when the wafer is settled in an immersed state on a wafer holding part of the single spin processor. Then, the inventors have reached the present invention.

It is an object of the present invention to provide a single wafer processor structured such that similar immersion treatment to the conventional immersion treatment can be performed in the spin treatment, that a consumption of the chemical solutions can be reduced in the chemical solution treatment per wafer, that energy saving can be realized by using reaction heat of the chemical solutions to eliminate a necessity of a heating heater, that the blending of the chemical solutions can be implemented by the nozzle means and/or a rotary disk part, thus setting a blended amount of the chemical solutions to the minimum necessary and making it possible to improve safety and reduce cost of the chemical solutions, accordingly, that it becomes possible to supply undiluted solutions of the chemical solutions, thus making it unnecessary to manage the blended chemical solution, which does not require circulation and heating, that a problem of deterioration of the chemical solutions can be eliminated since the blending of the chemical solutions is implemented on the rotary disk part and the chemical solutions are used immediately thereafter, and that the maximum effective point of the chemical solutions can be utilized, thus making it possible to reduce a concentration of the chemical solutions less than a conventional usage concentration of the chemical solutions.

### Means for solving the Problems

To solve the above-mentioned problems, in a first aspect, a single wafer processor according to the present invention includes: a rotary disk having medium flow passages on an upper surface thereof; a plurality of wafer receiving parts provided on the upper surface of the rotary disk; an annular dam member located outward of an outer circumferential edge of a wafer mounted on the wafer receiving parts and provided so that an upper edge of the annular dam member can be located at an upper level than an upper surface of the wafer thus mounted; and nozzle means, provided above the wafer mounted on the wafer receiving parts, for supplying a chemical solution and rinse water.

In the first aspect, the single wafer processor is configured so that a medium in the medium flow passage can be discharged to an outside by centrifugal force caused by rotation, for making a pressure-reduced state appear in the medium flow passage, and that the wafer can be sucked downward by suction force of the pressure-reduced state, and can be held by the wafer receiving parts. In the single wafer processor, it is possible that: the chemical solution or the rinse water is supplied from the nozzle means to an inside of the annular dam member so that the wafer can be settled in an immersed state in a state where the wafer is mounted above the rotary disk at an interval while interposing the wafer receiving parts therebetween, for performing chemical solution immersion treatment or immersion rinse treatment for the wafer; and the rotary disk is rotated at a high speed in a state where the wafer in the immersed state is held on the wafer receiving parts so that the chemical solution or the rinse water on the wafer and the rotary disk is shaken off.

In a second aspect, a single wafer processor according to the present invention includes: a rotary disk having medium flow passages on an upper surface thereof; a plurality of wafer receiving parts provided on the upper surface of the rotary disk; an annular dam member located outward of an outer circumferential edge of a wafer mounted on the wafer receiving parts and provided so that an upper edge of the annular dam member can be located at an upper level than an upper surface of the wafer thus mounted; nozzle means, provided above the wafer mounted on the wafer receivingparts, for supplying a chemical solution and rinse water; a through hole drilled in a center of the rotary disk; and supply means for supplying the chemical solution, the rinse water, or drying gas to the through hole.

In the second aspect, the single wafer processor is configured so that a medium in the medium flow passage can be discharged to an outside by centrifugal force caused by rotation, for making a pressure-reduced state appear in the medium flow passage, and that the wafer can be sucked downward by suction force of the pressure-reduced state, and can be held by the wafer receiving parts. In the single wafer processor, it is possible that: the chemical solution or the rinse water is supplied from the nozzle means and the through hole to an inside of the annular dam member so that the wafer can be settled in an immersed state in a state where the wafer is mounted above the rotary disk at an interval while interposing the wafer receiving parts therebetween, for performing chemical solution immersion treatment or immersion rinse treatment for the wafer; and the rotary disk is rotated at a high speed in a state where the wafer in the immersed state is held on the wafer receiving parts so that the chemical solution or the rinse water on the wafer and the rotary disk is shaken off; and drying treatment for the wafer is further performed by jetting and supplying drying gas from the through hole.

The single wafer processor is appropriately structured to further include: a rotary shaft in which a hollow portion communicating with the through hole is drilled in an axial direction, the rotary shaft being provided on a center of a lower surface of the rotary disk perpendicularly thereto, in which: when the chemical solution immersion treatment or the immersion rinse treatment for the wafer is performed, the chemical solution or the rinse water is supplied from a lower opening portion of the hollow portion of the rotary shaft through the hollow portion to the through hole; and when the drying treatment for the wafer is performed, the drying gas is supplied from the lower opening portion of the hollow portion of the rotary shaft through the hollow portion to the through hole.

Each of the wafer receiving parts is preferably composed of a lower-side guide pin that receives a lower surface of the wafer, and an outside guide pin that receives an outer side surface of the wafer.

It is possible that blade plates are provided on the upper surface of the rotary disk radially, in a helical shape, or in a swirl shape, and the medium flow passage is formed in a space among the upper surface of the rotary disk, the blade plates, each pair of which is opposite to each other, and the lower surface of the wafer. It is also possible that the wafer receiving parts are provided on upper surfaces of the blade plates.

It is possible to adopt a structure in which a baffle plate is provided above the through hole drilled in the center of the rotary disk, and the chemical solution or the rinse water, either of which is supplied through the through hole to the upper surface of the rotary disk, is guided in a direction of the blade plates by the baffle plate.

When a plurality of the chemical solutions are supplied as a blended chemical solution with a predetermined blending ratio, the individual chemical solutions are supplied from the nozzle means onto the wafer mounted on the wafer receiving parts in the predetermined blending ratio, and further, the individual chemical solutions are jetted and supplied from the through hole onto the upper surface of the rotary disk in the predetermined blending ratio. In this way, the blended amount of the chemical solutions is minimized, and it is possible to improve the safety and reduce the cost of the chemical solutions. Consequently, it is possible to supply the undiluted solutions of the chemical solutions, thus making it unnecessary to manage the blended chemical solution which does not require the circulation and the heating. Further, the problem of the deterioration of the chemical solutions is eliminated since the blending of the chemical solutions is implemented on the rotary disk part and the chemical solutions are used immediately thereafter. Further, the maximum effective point of the chemical solutions can be utilized, thus making it possible to reduce the concentration of the chemical solutions than the conventional usage concentration of the chemical solutions.

### Effect of the Invention

According to the single wafer processor of the present invention, the similar immersion treatment to the conventional immersion treatment can be performed in the spin treatment, the consumption of the chemical solutions can be reduced in the chemical solution treatment per wafer, the heating heater is made unnecessary and the energy saving is possible by using the reaction heat of the chemical solutions, and the blending of the chemical solutions is implemented by the nozzle means and/or the rotary disk part, thus setting the blended amount of the chemical solutions to the minimum necessary and making it possible to improve the safety and reduce the cost of the chemical solutions.

### Brief description of the Drawings

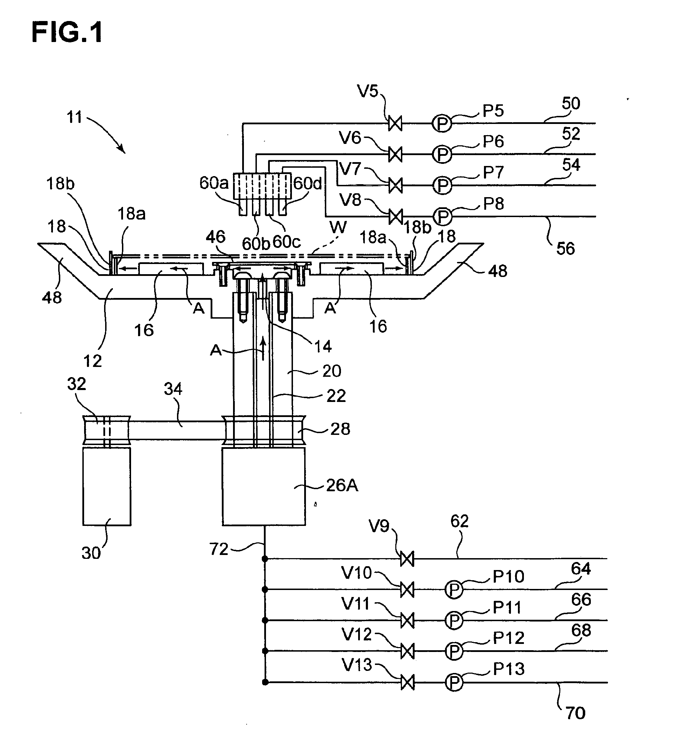

FIG. 1 is a schematic explanatory view of a cross-sectional side surface, showing an embodiment of a single wafer processor according to the present invention.

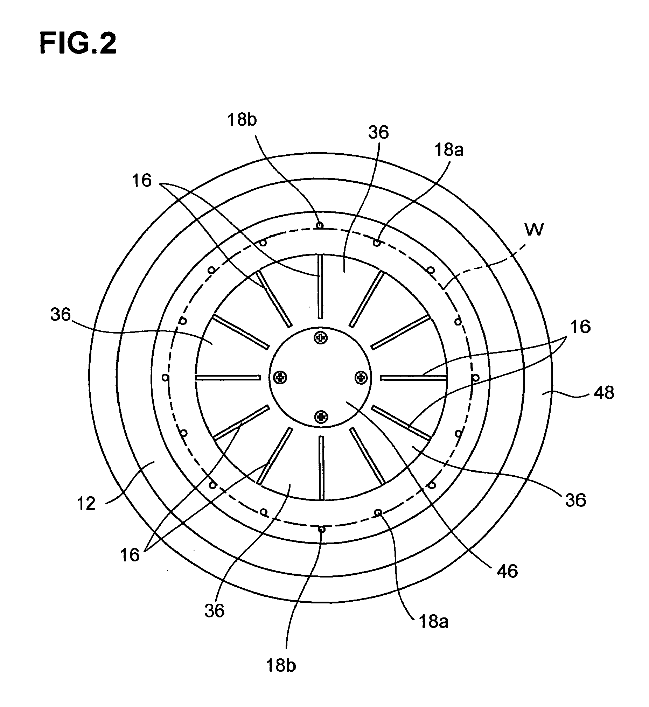

FIG. 2 is an enlarged plan view of a rotary disk part of FIG. 1.

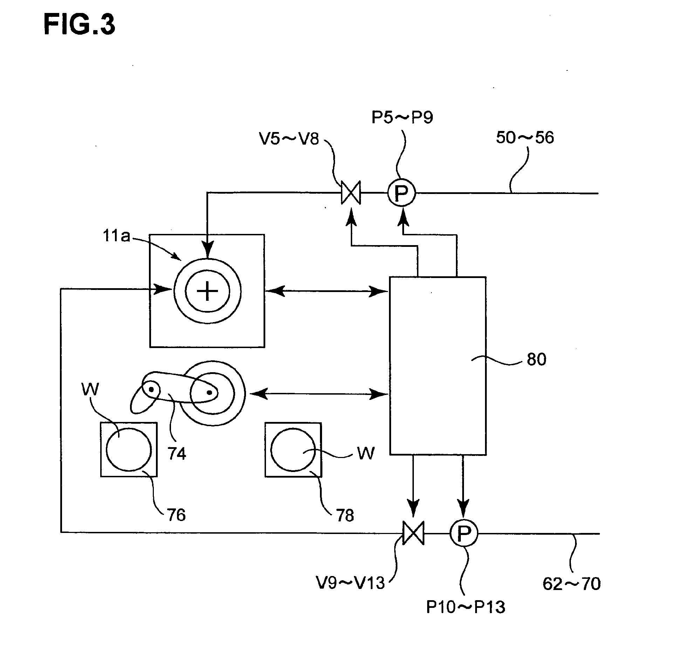

FIG. 3 is an explanatory view showing an electrical connection state between the respective members of the single wafer processor shown in FIG. 1 and a controller.

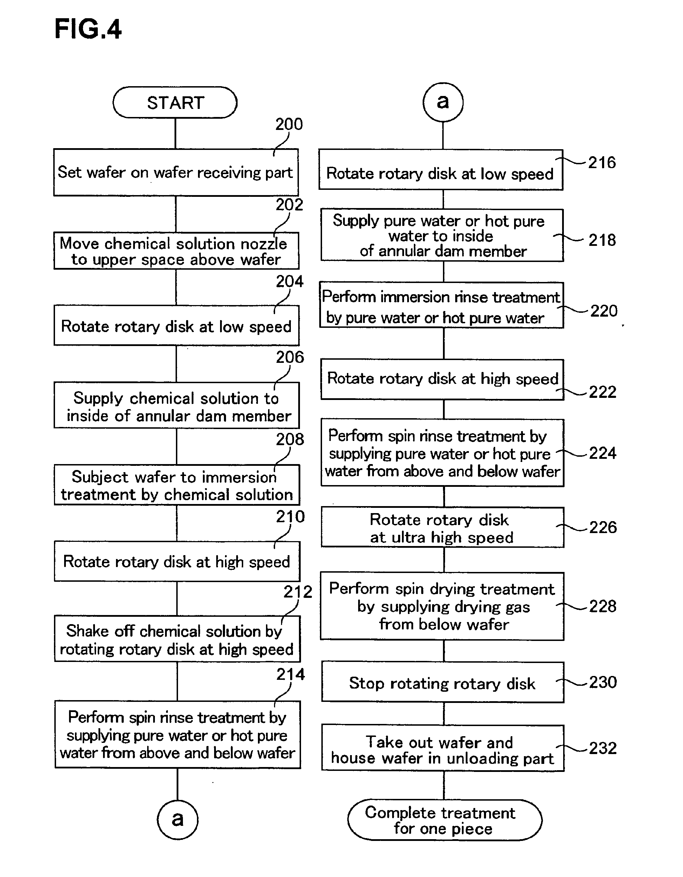

FIG. 4 is a flowchart showing an example of an operation procedure of wafer immersion treatment using the single wafer processor of the present invention.

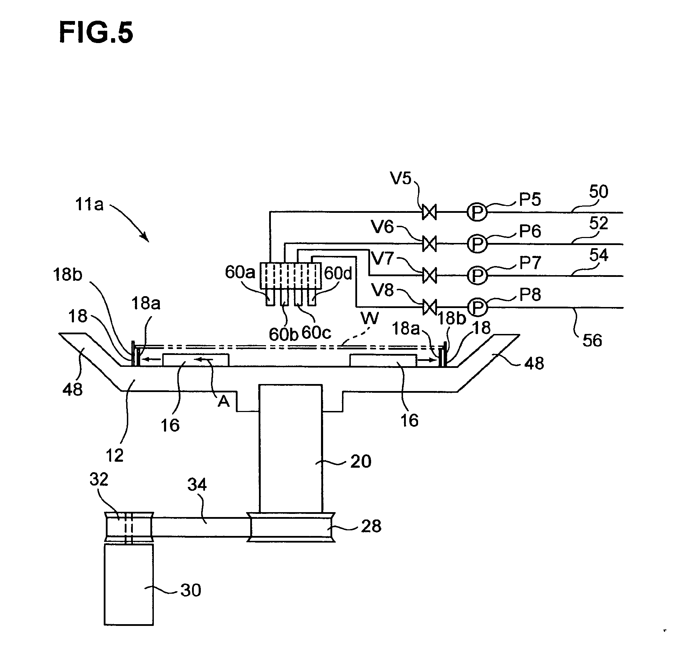

FIG. 5 is a schematic explanatory view of a cross-sectional side surface, showing another embodiment of the single wafer processor according to the present invention.
FIG. 6 is a perspective explanatory view showing an example of a conventional single wafer processor.
FIG. 7 is a perspective explanatory view showing a state of holding a wafer on the wafer holding apparatus of FIG. 6.

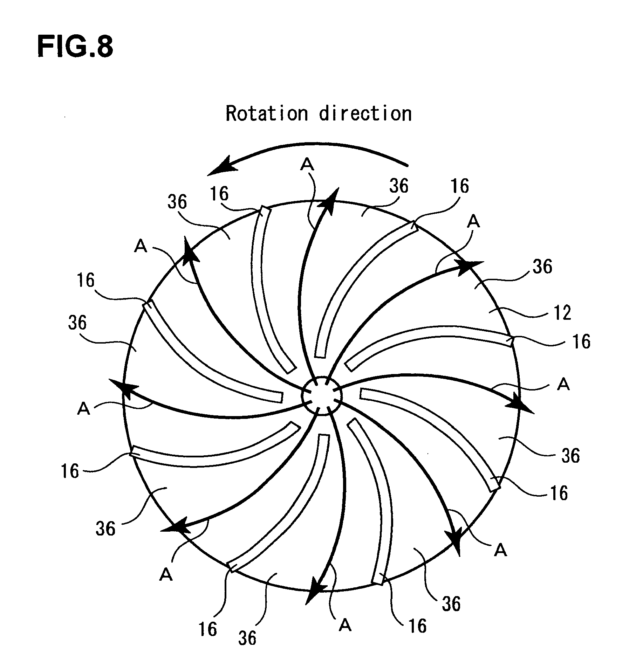

FIG. 8 is a plan view showing another example of blade plates.
FIG. 9 is a plan view showing another example of the blade plates.
FIG. 10 is a schematic explanatory view showing a supply mechanism of the chemical solutions and the like in the conventional single wafer processor.

### Description of Reference Symbols

10: a conventional single wafer processor, 11, 11a: single wafer processors of the present invention 12: a rotary disk, 14: a through hole, 16: a blade plate, 18: a wafer receiving part, 20: a rotary shaft, 22: a hollow portion, 24: a lower opening portion, 26: a pressure reducing means, 26A: a rotary joint, 28: a pulley, 30: a motor, 32: a motor pulley, 34: a pulley belt, 46: a baffle plate, 48: an annular dam member, A: a medium, W: a wafer Best Mode for carrying out the Invention

A description will be made below of embodiments of the present invention with reference to the accompanying drawings; however, it is needless to say that a variety of modifications other than in illustrated examples are possible without departing from a technical concept of the present invention.

FIG. 1 is a schematic explanatory view of a cross-sectional side surface, showing an embodiment of a single wafer processor according to the present invention. FIG. 2 is an enlarged plan view of a rotary disk of FIG. 1. In FIGS. 1 and 2, the identical or similar members to those of FIGS. 6 and 7 are denoted by the same reference symbols.

In FIG. 1, reference symbol 11 denotes the single wafer processor of the present invention, which has a rotary disk 12 in which medium flow passages are formed on an upper surface. On the upper surface of the rotary disk 12, a plurality of wafer receiving parts 18 are provided. Unlike in the example shown in FIGS. 6 and 7, each of the wafer receiving parts 18 is composed of a lower-side guide pin 18a that receives a lower surface of a wafer W, and an outside guide pin 18b that receives an outer side surface of the wafer W. Reference symbol 48 denotes an annular dammember provided on an outer circumference of the rotary disk 12. The annular dam member 48 is formed so as to be located outward of an outer circumferential edge of the wafer W mounted on the wafer receiving parts 18 and so that an upper edge of the annular dam member 48 can be located at an upper level than an upper surface of the wafer thus mounted. Reference symbol 60 denotes swing nozzle means, and the swing nozzle means 60 is provided above the wafer W mounted on the wafer receiving parts 18, and functions to eject and supply a chemical solution such as sulfuric acid and a hydrogen peroxide solution, and rinse water such as pure water and hot pure water.

Reference symbol 50 denotes an upper conduit for a first chemical solution, for example, the sulfuric acid, in which pump means P5 and valve means V5 are provided. Reference symbol 52 denotes an upper conduit for a second chemical solution, for example, the hydrogen peroxide solution, in which pump means P6 and valve means V6 are provided. Reference symbol 54 denotes an upper conduit for the pure water, in which pump means P7 and valve means V7 are provided. Reference symbol 56 denotes an upper conduit for the hot pure water, in which pump means P8 and valve means V8 are provided. The respective upper conduits 50, 52, 54 and 56 described above are connected to the swing nozzle means 60 disposed above the rotary disk 12. On the swing nozzle means 60, there are protruded a first nozzle 60a, a second nozzle 60b, a third nozzle 60c, and a fourth nozzle 60d. The first nozzle 60a is configured to eject and supply the first chemical solution. The second nozzle 60b is configured to eject and supply the second chemical solution. The third nozzle 60c is configured to eject and supply the pure water. The fourth nozzle 60d is configured to eject and supply the hot pure water.

A through hole 14 is drilled in a center of the rotary disk 12. Reference symbol 20 denotes a rotary shaft provided on a center of the lower surface of the rotary disk 12 perpendicularly thereto, and in an axial direction thereof, a hollow portion 22 communicating with the through hole 14 is drilled. On a lower end of the rotary shaft 20, a rotary joint 26A is provided so as to communicate with the hollow portion 22.

Reference symbol 62 denotes a lower conduit for drying gas, for example, nitrogen gas or the air, in which valve means V9 is provided. Reference symbol 64 denotes a lower conduit for the first chemical solution, for example, the sulfuric acid, in which pump means P10 and valve means V10 are provided. Reference symbol 66 denotes a lower conduit for the second chemical solution, for example, the hydrogen peroxide, in which pump means P11 and valve means V11 are provided. Reference symbol 68 denotes a lower conduit for the pure water, in which pump means P12 and valve means V12 are provided. Reference symbol 70 denotes a lower conduit for the hot pure water, in which pump means P13 and valve means V13 are provided. The respective lower conduits 62, 64, 66, 68 and 70 described above are connected to the rotary joint 26A through a main conduit 72. The medium A such as the drying gas, the first chemical solution, the second chemical solution, the pure water, and the hot pure water, in which a flow rate is adjusted by the rotary joint 26A, is supplied to the upper surface side of the rotary disk 12 through the hollow portion 22 of the rotary shaft 20. Hence, supply means for supplying the chemical solutions, the rinse water, or the drying gas to the through hole 14 from the lower surface side of the rotary disk 12 is composed of the above-mentioned pump means P10 to P13, the respective lower conduits 62, 64, 66, 68 and 70 described above, the main conduit 72, and the like as well as the hollow portion 22 of the rotary shaft 20. In the case of performing chemical solution immersion treatment or immersion rinse treatment for the above-mentioned wafer, each chemical solution or the rinse water is supplied to the through hole from the lower surface side of the rotary disk, and in the case of performing drying treatment for the wafer, the drying gas is supplied to the through hole from the lower surface side of the rotary disk.

Reference symbol 46 denotes a baffle plate provided on the rotary disk 12 so as to be located above the through hole 14 drilled in the center of the rotary disk 12. The medium A supplied to the upper surface of the rotary disk 12 through the through hole 14 is guided to a direction of the blade plates 16 by the baffle plate 46.

By installment of the baffle plate 46, the medium A is not directly sprayed onto the lower surface of the wafer W, and accordingly, an accident that the wafer W is contaminated with impurities and the like is prevented even if the impurities are mixed into the medium A. Further, there is an advantage in that an upward blowout of the medium A when the wafer W is broken during the operation is prevented.

FIG. 3 is an explanatory view showing an electrical connection state between the respective members of the single wafer processor shown in FIG. 1 and a controller. In FIG. 3, reference symbol 74 denotes a handling robot installed adjacent to a single wafer processor body 11a. The handling robot 74 operates so as to carry and mount the wafer W mounted on a wafer loading part 76 onto the wafer receiving parts 18, and to carry and mount the wafer W mounted on the wafer receiving parts 18 onto a wafer unloading part 78. Reference symbol 80 denotes the controller, and the controller 80 is electrically connected to the single wafer processor body 11a, the handling robot 74, the valve means V5 to V8 and V9 to V13, and the pump means P5 to P8 and P10 to P13, and performs a control for spin treatment, a control for the handling robot, and a control for the respective valve means and pump means. Note that a configuration other than those described above is similar to the configuration of FIGS. 6 and 7, and accordingly, a repeated explanation thereof will be omitted.

With the above-mentioned configuration, the chemical solution or the rinse water is supplied to an inside of the annular dam member 48 while rotating the rotary disk 12 at a low speed in a state where the wafer W is mounted above the rotary disk 12 at an interval with the wafer receiving parts 18 interposed therebetween so that the wafer W can be settled in an immersed state. In this way, the chemical solution immersion treatment or the immersion rinse treatment for the wafer W is performed. Subsequently, the rotary disk 12 is rotated at a high speed in a state where the wafer W in the immersed state is held on the wafer receiving parts 18, thereby making it possible to shake off the chemical solution or the rinse water on the wafer receiving part 18 and the rotary disk 12 or to perform the drying treatment for the wafer W. In a similar manner as in the apparatus shown in FIGS. 6 and 7, when the rotary disk 12 is rotated, the medium (chemical solution and the like in the case of FIG. 1) on the upper surface of the rotary disk 12 is discharged to the outside by centrifugal force caused by the rotation. Specifically, the medium A that has passed through the through hole 14 is guided to the side through a lower surface of the baffle plate 46, and subsequently, the medium A on the rotary disk 12 is discharged to the outside through the plurality of medium flow passages 36 formed in spaces among the upper surface of the rotary disk 12, the blade plates 16, each pair of which is opposite to each other, and the lower surface of the wafer W.

A description will be more specifically made of an operation procedure of the wafer immersion treatment using the single wafer processor of the present invention with reference to a flowchart shown in FIG. 4.

First, the wafer W is set onto the wafer receiving parts 18 from the wafer loading part 76 by using the handling robot 74 (Step 200). The nozzle means 60 is moved to the upper space above the wafer W (Step 202). Next, the rotary disk 12 is rotated at a low speed (0 to 100 rpm) (Step 204).

The chemical solutions (for example, sulfuric acid and hydrogen peroxide solution) are supplied to the inside of the annular dam member 48 while rotating the rotary disk 12 at the low speed in a state where the wafer W is mounted above the rotary disk 12 at an interval with the wafer receiving parts 18 interposed therebetween so that the wafer W can be settled in the immersed state.

Specifically, the valve means V5 and V6 are opened, the pump means P5 and P6 are operated, and the chemical solutions are fed into the nozzle means 60. Then, the chemical solutions are ejected and jetted onto the upper surface of the wafer W by the nozzle means 60. Further, the valve means V10 and V11 are opened, and the pump means P10 and P11 are operated. In this way, the chemical solutions are ejected and supplied onto the upper surface of the rotary disk 12 from the through hole 14 through the rotary joint 26A and the hollow portion 22, whereby the chemical solutions are filled into the inside of the annular dam member 48 so that the wafer W can be settled in the immersed state (Step 206).

The wafer W is immersed into the chemical solutions for a predetermined time (for example, approximately 5 to 10 minutes), whereby the immersion treatment for the wafer W is performed (Step 208) . In a state where the wafer W in the immersed state is held on the wafer receiving parts 18, the rotary disk 12 is rotated at the high speed (approximately 500 to 2000 rpm) (Step 210).

Such high-speed rotation is performed for a predetermined time (for example, approximately 30 seconds), whereby the chemical solutions on the wafer receiving part 18 and the rotary disk 12 are shaken off (Step 212). In a state where the wafer W is rotated at the high speed, the valve means V7 or V8 is opened, the pump means P7 or P8 is operated, and the pure water or the hot pure water is fed into the nozzle means 60. In this way, the pure water or the hot pure water is ejected and jetted onto the upper surface of the wafer W by the nozzle means 60. Further, the valve means V12 or V13 is opened, the pump means P12 or P13 is operated, and the pure water or the hot pure water is ejected and supplied onto the upper surface of the rotary disk 12 from the through hole 14 through the rotary joint 26A and the hollow portion 22. In this way, spin rinse treatment for the wafer W from which the chemical solutions are shaken off is performed (Step 214) .

After the rinse treatment is ended, the rotation of the rotary disk 12 is set as the low-speed rotation (0 to 100 rpm) (Step 216). The pure water or the hot pure water is supplied to the inside of the annular dam member 48 while rotating the rotary disk 12 at the low speed so that the wafer W can be settled in the immersed state.

Specifically, the valve means V7 or V8 is opened, and the pump means P7 or P8 is operated, and the pure water or the hot pure water is fed into the nozzle means 60. In this way, the pure water or the hot pure water is ejected and jetted onto the upper surface of the wafer W by the nozzle means 60. Further, the valve means V12 or V13 is opened, the pump means P12 or P13 is operated, and the pure water or the hot pure water is ejected and supplied onto the upper surface of the rotary disk 12 from the through hole 14 through the rotary joint 26A and the hollow portion 22. In this way, the pure water or the hot pure water is filled into the inside of the annular dam member 48 so that the wafer W can be settled in the immersed state (Step 218).

The wafer W is immersed into the pure water or the hot pure water for a predetermined time (for example, approximately 1 minute), whereby the immersion rinse treatment for the wafer W is performed (Step 220). In a state where the wafer W in the immersed state is held on the wafer receiving parts 18, the rotary disk 12 is rotated at the high speed (approximately 500 to 2000 rpm) (Step 222).

In a state where the wafer W is rotated at the high speed, the valve means V7 or V8 is opened, the pump means P7 or P8 is operated, and the pure water or the hot pure water is fed into the nozzle means 60. In this way, the pure water or the hot pure water is ejected and jetted onto the upper surface of the wafer W by the nozzle means 60. Further, the valve means V12 or V13 is opened, the pump means P12 or P13 is operated, and the pure water or the hot pure water is ejected and supplied onto the upper surface of the rotary disk 12 from the through hole 14 through the rotary joint 26A and the hollow portion 22. In this way, the spin rinse treatment for the wafer W is performed (Step 224).

After the spin rinse treatment, the rotary disk 12 is rotated at an ultra high speed (approximately 1500 to 2500 rpm) (Step226) . In a state where the wafer W is rotated at the ultra high speed, the valve means V9 is opened and the drying gas (for example, nitrogen or air) is ejected and supplied onto the upper surface of the rotary disk 12 from the through hole 14 through the rotary joint 26A and the hollow portion 22. In this way, spin drying treatment for the wafer W is performed (Step 228).

After the spin drying treatment is ended, the rotation of the rotary disk 12 is stopped (Step 230). Finally, the wafer W for which the immersion treatments are ended is taken out of the wafer receiving parts 18 by using the handling robot 74, and is housed in the wafer unloading part 78 (Step 232).

A description will be made of functions obtained by using the apparatus of the present invention. In the spin treatment by the apparatus of the present invention, the plurality of chemical solutions are flown down on the rotary disk 12 and are blended there, and accordingly, it is necessary to improve a mixed state of the chemical solutions. Therefore, a configuration can be adopted, in which the rotary disk is rotated normally and reversely. Further, it is preferable to set intermittent ejection conditions so that the respective chemical solutions ejected from the nozzle means 60 cannot be synchronized with each other in order to prevent the chemical solutions from being ejected continuously.

With regard to utilization of reaction heat when the chemical solutions are prepared, a mixed solution of the sulfuric acid and the hydrogen peroxide solution is present as a chemical solution of which reaction heat is particularly usable, and the mixed solution is utilized for the purpose of removing an organic substance in a device process, and is used also for removing a resist film. It is frequent that a mixing ratio of the mixed solution is 4 to 1 for the sulfuric acid to the hydrogen peroxide solution by weight, and a usage temperature thereof is approximately 80°C to 130°C. It is possible to deal with the reaction heat generated at the time of the mixing in the above-mentioned ratio if a temperature of an undiluted solution is raised up to approximately 55°C in advance in a case where the usage temperature is in a high-temperature range of 130°C. This is because the entire mixed solution is heated up from 25°C to approximately 100°C. Further, the undiluted solution becomes usable while being left at room temperature if the usage temperature is approximately 100°C.

In a case of a mixed solution with little reaction heat, in a case of a mixed solution such as SC-1 and SC-2 in the RCA cleaning is used, a major component thereof is water, and accordingly, the mixed solution is mixed as hot water, thereby making it possible to adj ust the temperature of the mixed solution to the target temperature.

In a case of a chemical solution and a chemical solution, both of which have little reaction heat, undiluted solutions thereof are heated in advance and then supplied. In this case, chemical solutions in which deterioration owing to the heating is little are heated and supplied in consideration of a blending ratio of the chemical solutions, thereby making it possible to suppress the deterioration of the chemical solutions to the minimum.

In the embodiment of the apparatus of the present invention, which is shown in FIGS. 1 to 4, as the means and method of supplying the chemical solutions and the like to the inside of the annular dam member 48, the description is made of the example of a mode of supplying the chemical solutions and the like in both of the upper and lower directions, in which the chemical solutions and the like are jetted from the through hole 14 drilled in the center of the rotary disk 12, as well as the chemical solutions and the like are flown down from the above by the nozzle means 60. However, even if the configuration of supplying the chemical solutions and the like from the below, that is, jetting the chemical solutions and the like from the through hole 14 is omitted, the functions and effects of the present invention are sufficiently achieved. A description will be made below of such a configuration.

FIG. 5 is a schematic explanatory view of a cross-sectional side surface, showing another embodiment of the single wafer processor according to the present invention. In FIG. 5, the identical or similar members to those of FIG. 1 are denoted by the same reference symbols.

In FIG. 5, reference symbol 11a denotes the single wafer processor of the present invention, in which a different point from that of the apparatus shown in FIG. 1 is that there are omitted the through hole 12, the hollow portion 22, the rotary joint 26A, the baffle plate 46, the lower conduits 62, 64, 66, 68, and 70, and the main conduit 72. The other configurations are completely the same as those of the processor 11 of FIG. 1, and a repeated explanation thereof will be omitted. Further, functions of the apparatus of this embodiment are completely the same as those shown in the flowchart of FIG. 4 except that there is no supply of the chemical reactions and the like from the below, and a repeated explanation thereof will be omitted similarly.

Note that, in the processor 11 shown in FIG. 1, the drying gas (for example, nitrogen or air) supplied by the lower conduit 62 functions to prevent diffraction of the chemical solutions and the like to the lower surface of the wafer, to prevent excessive adsorption of the chemical solutions and the like to the center of the lower surface of the wafer, and the like, as well as functions to dry the wafer. However, in the processor 11a of FIG. 5, there is an inconvenience that it is not possible to spray the drying gas from the below. In the processor 11a of FIG. 5, the spray of the drying gas just needs to be performed by providing spraying means (not shown) other than the nozzle means.

### Industrial Applicability

According to the single wafer processor of the present invention, it is possible to supply the undiluted solutions of the chemical solutions, thereby making it unnecessary to manage the blended chemical solution, which does not require the circulation and the heating. Further, it is possible to eliminate the problem of the deterioration of the chemical solutions since the blending of the chemical solutions is implemented in the nozzle means and/or the rotary disk part and the chemical solutions are used immediately thereafter, and to utilize the maximum effective point of the chemical solutions, thereby making it possible to reduce the concentration of the chemical solutions to be lower than the conventional usage concentration of the chemical solutions.

## Claims

1. A single wafer processor, comprising:
a rotary disk having medium flow passages on an upper surface thereof;
a plurality of wafer receiving parts provided on the upper
surface of the rotary disk;
an annular dam member located outward of an outer circumferential edge of a wafer mounted on the wafer receiving parts and provided so that an upper edge of the annular dam member can be located at an upper level than an upper surface of the wafer thus mounted; and
nozzle means, provided above the wafer mounted on the wafer
receiving parts, for supplying a chemical solution and rinse water.

2. The single wafer processor according to claim 1, which is configured so that a medium in the medium flow passage can be discharged to an outside by centrifugal force caused by rotation, for making a pressure-reduced state appear in the medium flow passage, and that the wafer can be sucked downward by suction force of the pressure-reduced state, and can be held by the wafer receiving parts, wherein:
the chemical solution or the rinse water is supplied from the nozzle means to an inside of the annular dam member so that the wafer can be settled in an immersed state in a state where the wafer is mounted above the rotary disk at an interval while interposing the wafer receiving parts therebetween, for performing chemical solution immersion treatment or immersion rinse treatment for the wafer; and
the rotary disk is rotated at a high speed in a state where the wafer in the immersed state is held on the wafer receiving parts so that the chemical solution or the rinse water on the wafer and the rotary disk is shaken off.

3. A single wafer processor, comprising:
a rotary disk having medium flow passages on an upper surface thereof;
a plurality of wafer receiving parts provided on the upper surface of the rotary disk;
an annular dam member located outward of an outer circumferential edge of a wafer mounted on the wafer receiving parts and provided so that an upper edge of the annular dam member can be located at an upper level than an upper surface of the wafer thus mounted;
nozzle means, provided above the wafer mounted on the wafer receivingparts, for supplying a chemical solution and rinse water;
a through hole drilled in a center of the rotary disk; and
supply means for supplying the chemical solution, the rinse water, or drying gas to the through hole.

4. The single wafer processor according to claim 3, which is configured so that a medium in the medium flow passage can be discharged to an outside by centrifugal force caused by rotation, for making a pressure-reduced state appear in the medium flow passage, and that the wafer can be sucked downward by suction force of the pressure-reduced state, and can be held by the wafer receiving parts, wherein:
the chemical solution or the rinse water is supplied from the nozzle means and the through hole to an inside of the annular dam member so that the wafer can be settled in an immersed state in a state where the wafer is mounted above the rotary disk at an interval while interposing the wafer receiving parts therebetween, for performing chemical solution immersion treatment or immersion rinse treatment for the wafer; and
the rotary disk is rotated at a high speed in a state where the wafer in the immersed state is held on the wafer receiving parts so that the chemical solution or the rinse water on the wafer and the rotary disk is shaken off; and
drying treatment for the wafer is further performed by jetting and supplying drying gas from the through hole.

5. The single wafer processor according to claim 3 or 4, further comprising:
a rotary shaft in which a hollow portion communicating with the through hole is drilled in an axial direction, the rotary shaft being provided on a center of a lower surface of the rotary disk perpendicularly thereto, wherein:
when the chemical solution immersion treatment or the immersion rinse treatment for the wafer is performed, the chemical solution or the rinse water is supplied from a lower opening portion of the hollow portion of the rotary shaft through the hollow portion to the through hole; and
when the drying treatment for the wafer is performed, the drying gas is supplied from the lower opening portion of the hollow portion of the rotary shaft through the hollow portion to the through hole.

6. The single wafer processor according to any one of claims 1 to 5, wherein each of the wafer receiving parts is composed of a lower-side guide pin that receives a lower surface of the wafer, and an outside guide pin that receives an outer side surface of the wafer.

7. The single wafer processor according to any one of claims 1 to 6, wherein blade plates are provided on the upper surface of the rotary disk radially, in a helical shape, or in a swirl shape, and the medium flow passage is formed in a space among the upper surface of the rotary disk, the blade plates, each pair of which is opposite to each other, and the lower surface of the wafer.

8. The single wafer processor according to claim 7, wherein the wafer receiving parts are provided on upper surfaces of the blade plates.

9. The single wafer processor according to claim 7 or 8, wherein a baffle plate is provided above the through hole drilled in the center of the rotary disk, and the chemical solution, the rinse water or the drying gas, any one of which is supplied through the through hole to the upper surface of the rotary disk, is guided in a direction of the blade plates by the baffle plate.

10. The single wafer processor according to any one of claims 1 to 9, wherein, when a plurality of the chemical solutions are supplied as a blended chemical solution with a predetermined blending ratio, the individual chemical solutions are supplied from the nozzle means onto the wafer mounted on the wafer receiving parts in the predetermined blending ratio.

11. The single wafer processor according to any one of claims 3 to 10, wherein, when a plurality of the chemical solutions are supplied as a blended chemical solution with a predetermined blending ratio, the individual chemical solutions are jetted and supplied from the through hole onto the upper surface of the rotary disk in the predetermined blending ratio.
